# EUROPEAN PATENT APPLICATION

(11) **EP 4 220 680 A1**
(43) Date of publication of application: **02.08.2023**
(21) Application number: 23152813.4
(22) Date of filing: 23.01.2023
(51) Int. Cl.: H01J 37/09, H01J 37/28

(54) **CHARGED-PARTICLE BEAM DEVICE FOR DIFFRACTION ANALYSIS**

(30) Priority: 28.01.2022 EP 22153925
(71) Applicant: ELDICO Scientific AG, 5234 Villigen (CH)
(72) Inventor: VAN VEEN, Alexander, 2595HJ Den Haag (NL); STEINFELD, Gunther, 8820 Waedenswil (CH); NIEBEL, Harald, 73447 Oberkochen (DE); HOVESTREYDT, Eric, 76149 Karlsruhe (DE); TUOHIMAA, Tomi, 11241 Stockholm (SE)
(74) Representative: Bohest AG

(57) **Abstract**

The present invention relates to a charged-particle beam device (1) for diffraction analysis, e.g. for charged-particle-crystallography of crystalline samples, comprising a charged-particle source (4) for generating a charged-particle beam (2) and a charged-particle-optical system downstream the charged-particle source (2) which is configured to be selectively operated in a diffraction mode and in an imaging mode. The charged-particle-optical system comprises a charged-particle lens system (5) consisting of a first magnetic lens (51) and a second magnetic lens (52) downstream the first magnetic lens (51), wherein at least the first magnetic lens (51) has a variable focal length. In addition, the charged-particle-optical system comprises a beam-limiting multiple-aperture stop (6) comprising at least two apertures (61, 62), one for each mode, as well as an aperture-swap deflector system (3) configured to selectively direct the charged-particle beam (2) through one of the two apertures (61, 62) in each mode. Alternatively, the beam-limiting multiple-aperture stop may be movable by means of an aperture-swap translation stage in at least one dimension within a movement plane perpendicular to the optical axis of the charged-particle-optical system such that the appropriate aperture intended for a particular mode can be moved into the charged-particle beam without the need for deflecting the beam.

## Description

### FIELD OF THE INVENTION

The invention relates to a charged-particle beam device, in particular a diffractometer, for diffraction analysis, e.g. for charged-particle-crystallography of crystalline samples, comprising a charged-particle source for generating a charged-particle beam and a charged-particle-optical system downstream the charged-particle source.

### BACKGROUND ART

Crystallography is an essential technology in most fields of chemistry, in particular for structure determination of crystalline samples. For many decades, X-ray diffraction analysis has been the main technology for structure determination. However, X-ray diffraction analysis requires large and well-ordered crystals to obtain reflections from diffracted beams of significant intensity required for sufficient data collection. For analyzing smaller samples, in particular those which are difficult to be grown to a sufficiently large size, it has been proposed to use charged-particles, such as electrons, for structure determination. In contrast to X-ray diffraction, charged-particle diffraction imposes virtually no lower size limit to the crystal. For example, using a beam of accelerated electrons allows for recording diffraction patterns of nano-crystalline samples having a diameter of less than one micrometer down to several nanometers which correspond to only a few repeating units of crystal building blocks. In principle, all types of charged-particle beams can be used. A predominant example for structure using charged-particle beams is electron microscopy and electron diffractometry.

Devices primarily designed for electron diffraction analysis are rather rare. Therefore, electron diffraction analysis is usually performed in standard electron microscopes (EM), especially transmission electron microscopes (TEM), since the basic technical components of electron diffractometers and transmission electron microscopes (TEM) are the same.

For determining the structure of a crystalline sample by electron diffraction, standard EM imaging techniques are first used to acquire a series of images, ranging from overview images to highly magnified images, in order to identify a particular sample or particle on which the diffraction experiment is to be performed. However, the use of standard EM imaging techniques with a large sized electron beam at the position of the plane, where the sample is located, may introduce a significant amount of radiation into the sample. In particular, the large size of the electron beam causes all particles on the sample holder to be irradiated, independently from the chosen field of view. Thus, the initial imaging of the sample can already deteriorate or even destroy it. This problem particularly arises, when samples of sensitive material, such as organic or biological samples, have to be analyzed. Then, the timeframe for the overall analysis is limited, and the exposure of the sample to vacuum and electron radiation has to be minimized.

To reduce the amount of radiation, it is possible to use scanning transmission electron microscopy (STEM) techniques employing an electron beam with a reduced size at the position of the plane where the sample is located. In this way, the amount of radiation to which the sample is exposed can be reduced. Therefore, this approach yields significant advantages. However, the STEM mode and the diffraction mode require a different adjustment of the optical system. Readjustment is time-consuming and requires a significant operator experience. The required time for the readjustment may cause a sensitive sample to reach or pass a critical level of deterioration, so that no sensible diffraction analysis can be performed anymore.

It is therefore an object of the invention to provide a charged-particle beam device, in particular a diffractometer, for diffraction analysis, e.g. for charged-particle-crystallography of crystalline samples, comprising a charged-particle source for generating a charged-particle beam to be irradiated onto a sample and a charged-particle-optical system downstream of the charged-particle source that is improved over such devices known in the state of the art.

### SUMMARY

According to one aspect of the present invention, there is provided a charged-particle beam device for charged-particle crystallography of crystalline samples. The device comprises a charged-particle source for generating a charged-particle beam to be radiated onto a sample. The device further comprises a charged-particle-optical system downstream the charged-particle source, which is configured to be selectively operated in a diffraction mode and in an imaging mode. In the diffraction mode the charged-particle-optical system is configured to form a substantially parallel charged-particle beam at a predefined sample position, while in the imaging mode the charged-particle-optical system is configured to form a focused charged-particle beam having a focus at the predefined sample position. The charged-particle-optical system comprises:
- a charged-particle lens system consisting of a first magnetic lens and a second magnetic lens downstream the first magnetic lens, wherein at least the first magnetic lens, preferably each one of the first and the second magnetic lens has a variable focal length,
- a beam-limiting multiple-aperture stop comprising at least a first aperture and a second aperture for limiting the diameter of the charged-particle beam, and
- an aperture-swap deflector system configured to selectively direct the charged-particle beam through the first aperture in the diffraction mode and through the second aperture in the imaging mode.

According to the invention, it has been found that a fast and reliable switching between an imaging mode and a diffraction mode, whilst still having a good analyzing quality for each mode, can be realized by an optical system which comprises on the one hand a charged-particle lens system consisting of two magnetic lenses only and on the other hand a beam-limiting multiple-aperture stop comprising at least two apertures, one for each mode, in combination with an aperture-swap deflector system configured to selectively direct the charged-particle beam through one of the two apertures in each mode. When using such an optical system, no time-consuming adjustment is necessary anymore when changing between the two modes. In particular, the device is capable of switching between the imaging mode and the diffraction mode by merely changing the variable focal length of one of the two magnetic lenses and selectively deflecting the charged-particle beam through one of the two apertures, both of which can be achieved purely electrically.

In other words, the charged-particle beam device according to the present invention can be used in and/or can be switched between a diffraction mode and an imaging mode (and vice versa) without effectuating mechanical movements, in particular mechanical movements of parts that are arranged within a vacuum, but simply by changing electrical parameters that are applied to the respective devices, in particular to the magnetic lenses and the aperture-swap deflector system.

The size of each one of the first and second aperture is fixed. Preferably, the position of the beam-limiting multiple-aperture stop is also fixed, that this, the beam-limiting multiple-aperture stop preferably is arranged at a fixed position, in particular along and transverse to an optical axis of the charged-particle-optical system. As a result, the design and the manufacture of the charged-particle beam device is easier and less expensive. Due to the fixed aperture sizes and positions, the charged-particle beam device is also more reliable as compared to devices employing beam limiting apertures with a variable aperture size or position, as they are used with some present-day devices.

The aperture-swap deflector system may comprise different components or subsystems, each of which may have a different function. In particular, the aperture-swap deflector system may comprise a first aperture-swap deflector subsystem arranged upstream of the beam-limiting multiple-aperture stop, which preferably is configured to selectively direct the charged-particle beam through the first aperture in the diffraction mode and through the second aperture in the imaging mode. In addition, the aperture-swap deflector system may comprise a second aperture-swap deflector subsystem arranged downstream of the beam-limiting multiple-aperture stop, which preferably is configured to (re-)direct the beam downstream of the beam-limiting multiple-aperture stop onto the optical axis of the charged-particle-optical system and/or onto the predefined sample position.

Instead of using a beam-limiting multiple-aperture stop having a fixed position in combination with an aperture-swap deflector system, it is also possible to use a beam-limiting multiple-aperture stop that is movable in at least one dimension within a movement plane perpendicular to the optical axis of the charged-particle-optical system. Thus, the appropriate aperture intended for a particular mode can be moved into the charged-particle beam without the need for deflecting the beam. For a remote control of the aperture stop movement, there may be provided an aperture-swap translation stage configured to move the beam-limiting multiple-aperture stop between different positions within the movement plane such that in one position the beam passes through the one of the apertures in one of the modes, and that in another position the beam passes through another aperture in another mode.

Hence, according to another aspect of the present invention, there is provided a charged-particle beam device for charged-particle crystallography of crystalline samples. The device comprises a charged-particle source for generating a charged-particle beam to be radiated onto a sample. The device further comprises a charged-particle-optical system downstream the charged-particle source, which is configured to be selectively operated in a diffraction mode and in an imaging mode. In the diffraction mode the charged-particle-optical system is configured to form a substantially parallel charged-particle beam at a predefined sample position, while in the imaging mode the charged-particle-optical system is configured to form a focused charged-particle beam having a focus at the predefined sample position. The charged-particle-optical system comprises:
- a charged-particle lens system consisting of a first magnetic lens and a second magnetic lens downstream the first magnetic lens, wherein at least the first magnetic lens, preferably each one of the first and the second magnetic lens has a variable focal length,
- a beam-limiting multiple-aperture stop comprising at least a first aperture and a second aperture for limiting the diameter of the charged-particle beam, wherein the beam-limiting multiple-aperture stop is movable in at least one dimension within a movement plane perpendicular to an optical axis of the charged-particle-optical system, and
- an aperture-swap translation stage configured to move the beam-limiting multiple-aperture stop between different positions within the movement plane such that in a first position of the beam-limiting multiple-aperture stop the charged-particle beam passes through the first aperture in the diffraction mode and that in a second position of the beam-limiting multiple-aperture stop the charged-particle beam passes through the second aperture in the imaging mode.

To ensure a proper performance of the respective beam-limiting apertures, the aperture-swap translation stage preferably is configured to position the beam-limiting multiple-aperture stop at the first position and the second position with an accuracy of at most ± 5 nanometer, in particular ±1 nanometer within the movement plane.

For moving the beam-limiting multiple-aperture stop, the aperture-swap translation stage may comprise an actuator, in particular an electrical actuator, for example, a piezo actuator. The actuator preferably is vacuum-compatible in order to be arrangeable within the vacuum of the device. Advantageously, this makes a vacuum-feedthrough for mechanical moving parts obsolete. In this regard, piezo actuators are favorable as being vacuum-compatible. In addition, piezo actuators are capable of positioning the apertures within the above-mentioned accuracy ranges.

In the following, advantageous embodiments of the charged-particle beam device are described which relate to both aspects of the invention, that is, to the device comprising a beam-limiting multiple-aperture stop having a fixed position in combination with an aperture-swap deflector system as well as to the device comprising a movable beam-limiting multiple-aperture stop in combination with an aperture-swap translation stage.

In principle, the beam-limiting multiple-aperture stop may be arranged at different at positions along the optical axis of the charged-particle-optical system. In particular, the beam-limiting multiple-aperture stop may be arranged between the first magnetic lens and the second magnetic lens. Alternatively, the beam-limiting multiple-aperture stop may be arranged downstream the second magnetic lens. As used herein, the relative arrangement of "downstream" is meant to be seen in the direction of the charged-particle beam that is generated/released by the charged-particle source.

In particular, the beam-limiting multiple-aperture stop may be arranged downstream or upstream of the second magnetic lens at an axial distance of at most 300 millimeter, preferably at most 250 millimeter, more preferably at most 200 millimeter or at most 150 millimeter or at most 100 millimeter, from a center (a center plane) of the second magnetic lens. Likewise, the beam-limiting multiple-aperture stop may be arranged downstream or upstream of the second magnetic lens at an axial distance from a center (a center plane) of the second magnetic lens in a range between 5 millimeter and at most 300 millimeter, preferably between 5 millimeter and at most 250 millimeter, more preferably between 5 millimeter and at most 200 millimeter or between 5 millimeter and at most 150 millimeter or between 5 millimeter and at most 100 millimeter. It is also possible that the beam-limiting multiple-aperture stop may be arranged in a center plane of the second magnetic lens, that is, at zero axial distance from a center (a center plane) of the second magnetic lens. Advantageously, any of these arrangements allows for a very compact design of the charged-particle-optical system.

Though, in principle, no time-consuming adjustment is necessary anymore when changing between the two modes, it might be possible to perform some typical minor adjustments after switching between the two modes. For example, when switching from a diffraction mode into an imaging mode, it may be necessary to focus the focal point of the charged-particle beam in the imaging mode. However, this is quite simple as compared to present-day charged-particle beam devices. The first mode to start with may be either the diffraction mode or the imaging mode. Accordingly, the consecutive mode will be the imaging mode or the diffraction mode, respectively. Of course, it is also possible to change between the imaging mode and the diffraction mode (or vice versa) several times. The changeover may be effectuated by the operator. It is also possible that some automatization will be used, so that switching between the modes will be effectuated by a computer device or the like.

The focal point of the charged-particle beam may be at the predefined sample position, so that a high imaging quality may be achieved. However, it is additionally or alternatively possible to use a slight offset of the focal point with respect to the predefined sample position. Such a slight off-focal setting might be advantageous for finding a suitable area/volume within the sample, where the thus identified suitable area/volume will be subsequently used for a following diffraction mode analysis, as an example. This way, a time-consuming scanning of the sample can be advantageously shortened. In particular, in case a very sensitive sample and/or a sample with a short lifetime is used, a fast identification of the area of the sample to be further analyzed may improve the quality of the diffraction measurement significantly, or may even make such a measurement possible at all.

The charged-particle-optical system may be configured such that the diameter of the charged-particle beam at the sample position is in a range between 100 nanometer and 1000 nanometer, in particular between 220 nanometer and 250 nanometer in the diffraction mode. Likewise, the charged-particle-optical system may be configured such that in the (scanning or STEM) imaging mode the diameter of the charged-particle beam at the sample position is and in a range between 10 nanometer and 200 nanometer, preferably between 30 nanometer and 150 nanometer. It is to be understood that the lower limit for the charged-particle beam in the diffraction mode may be 80 nanometer, 120 nanometer, 150 nanometer, and 200 nanometer as well, while the upper limit may be 270 nanometer, 300 nanometer, 350 nanometer, 400 nanometer, 500 nanometer, 600 nanometer, 700 nanometer, 800 nanometer and 900 nanometer as well. Likewise, the diameter of the charge-particle beam may have a lower limit of 5 nanometer, 15 nanometer, 20 nanometer, 30 nanometer, 40 nanometer, 50 nanometer and 75 nanometer as well, while its upper limit may be 100 nanometer, 120 nanometer, 150 nanometer and 175 nanometer as well. It has been found that the described ranges, lower limits and/or upper limits are particularly advantageous for the charged-particle beam device according to the present invention while maintaining good imaging properties of the charged-particle beam device.

The beam-limiting multiple-aperture stop with may be a plate having at least a first opening and a second opening therethrough defining the first aperture and the second, respectively. Further, it should be kept in mind that the beam-limiting multiple-aperture stop (and possibly other parts of the charged-particle beam device) is (are) arranged within a vacuum, so that the charged-particle beam will not be diverted or dampened by the gas to be passed through (in case there is no vacuum). Therefore, in case of electron beams with an electron beam energy a plate made of steel with a thickness in the order of 1 millimeter, 2 millimeter or 3 millimeter may be used for the beam-limiting multiple-aperture stop. The beam-limiting multiple-aperture stop may also be made of gold, platinum or molybdenum.

With respect to the dimensions of the optical system it has been found that the aperture diameter preferably is chosen large enough to avoid an obstruction of the aperture. According to one specific embodiment of the present invention, the first aperture may have an aperture diameter in a range between 1 micrometer and 10 micrometer, in particular between 4 micrometer and 7 micrometer, whereas the second aperture may have an aperture diameter in a range between 100 micrometer and 200 micrometer, in particular between 150 micrometer and 175 micrometer. In principle, the first and second apertures may even have larger aperture sizes. However, it must be considered that the greater the aperture size, the greater the overall length of the optical system, i.e. the distance between the virtual position of the charged-particle source and the predefined sample position. Accordingly, a more compact design of the charged-particle beam device may be achieved by a selecting smaller aperture sizes.

The charged-particle-optical system may further comprise a scanning deflector system arranged between the first magnetic lens and the second magnetic lens for two-dimensionally scanning the charged-particle beam at the predefined sample position. Advantageously, this allows for operating the charged-particle beam device in a scanning imaging mode which is essentially equivalent to the scanning imaging mode of a scanning transmission electron microscope (STEM) or a raster-scanning transmission electron microscope (RSTEM). Preferably, a pivot point of the scanning deflector system may be on an optical axis in a principal plane of the second magnetic lens. Advantageously, this facilitates the operational implementation of a scanning imaging mode. The scanning deflector system may comprise a first scanning beam deflector and a second scanning beam deflector. It has been found that when using a double deflector arrangement with two beam deflectors (or a multiple deflector arrangement with three, four, five, six, seven or eight beam deflectors), the overall performance of the charged-particle beam device can be increased with usually no or little additional costs and/or without significant additional complexity.

The charged-particle optical system may further comprise an alignment deflector system to facilitate the initial alignment of the optical system. The alignment deflector system may comprise at least a first alignment beam deflector arranged upstream the first magnetic lens and preferably a second alignment beam deflector arranged between the first magnetic lens and the second magnetic lens. The second alignment beam deflector may also be used as the first aperture-swap deflector subsystem, or vice versa. That is, either the second alignment beam deflector or the first aperture-swap deflector subsystem may be used to implement the function of both, the second alignment beam deflector and the first aperture-swap deflector subsystem.

The charged-particle optical system may further comprise a scraping aperture arranged between the charged-particle source and the first magnetic lens. The scraping aperture serves to scrap of electron outside a preferred divergence cone. Thus, imaging errors due to a divergence (non-parallelism) of the charged-particle beam in the diffraction mode and/or when operating in the imaging mode, the smearing of the focal point for differently angled incident beam paths, when seen in the direction of the propagation of the charged-particle beam, can be reduced. This way, the imaging quality of the resulting charged-particle device can be increased even further.

In particular when using a high energy electron beam, the charged-particle beam device preferably comprises a cooling equipment for cooling the scraping aperture. This way, the lifetime of the charged-particle beam device can be increased, since the impact of the continuous flux of accelerated charged particles onto the scraping aperture can lead to a substantial temperature increase that might be problematic for the scraping aperture or parts nearby. Furthermore, such a temperature increase can lead to diffusion effects that in turn might lower the quality of the vacuum.

The charged-particle-optical system may further comprise a charged-particle stigmator to correct for astigmatism. Ideally, the charged-particle stigmator is arranged at a position of the widest beam diameter, but can be shifted a little from the ideal position to make room for other components of the charged-particle-optical system. It has been found that the presently suggested arrangement and the position of the charged-particle stigmator is particularly suitable for increasing the imaging quality of the charged-particle beam device. It is to be noted that charged-particle stigmators are well known in the present field of technology. In particular, charged-particle stigmators that are commercially available can be used for the presently suggested design.

Preferably, not only the first magnetic lens, but also the second magnetic lens has a variable focal length. Advantageously, this may allow to adjust the optical system more easily, for example, to adjust the focal point of the charged-particle beam in the imaging mode, as discussed above.

In particular, the first magnetic lens may be configured such that a focal length of the first magnetic lens is in a range between 10 millimeter and 30 millimeter, in particular 20 millimeter, in the diffraction mode, and in a range between 2 millimeter and 6 millimeter, in particular 4 millimeter, in the imaging mode. Likewise, the second magnetic lens may be configured such that a focal length of the second magnetic lens is in a range between 12 millimeter and 25 millimeter, in particular 18 millimeter, in at least one of the diffraction mode and the imaging mode. These design parameters have proven to be advantageous for the presently suggested design.

Preferably, the charged-particle-optical system comprises no further magnetic lens or lens system other than the charged-particle lens system consisting of the first and the second magnetic lenses. Due to this, the complexity of the charged-particle beam device can be reduced, resulting in a more robust and more cost-efficient design with a possibly increased lifetime due to the simpler and less complex design.

In principle, all types of magnetic lenses with a fixed and/or a variable focal length that are used in the present field of technology can be used as a magnetic lens in the device according to the present invention. Thus, the charged-particle beam device is easy, less expensive and faster to be manufactured, since the construction may be based on a variety of readily available devices that are commercially available.

The above said also applies to the charged-particle source for generating the charged-particle beam to be irradiated onto the sample and/or possibly applies to other devices, means, parts and/or constructions that are used for the presently suggested charged-particle beam device, in particular including the modifications that will be elaborated in the following in more detail.

Preferably, the charged-particle beam is an electron beam. Accordingly, the charged-particle source preferably is an electron source. As compared to X-ray diffraction, the interaction between electrons and the atoms of the crystalline sample is much larger, allowing to observe diffraction patterns of crystals having a diameter of the less than one micrometer down to several nanometers. In principle, it is also possible to use different charged particles, like protons, helium atom ions/helium nuclei or the like.

Preferably, the electron source is configured to generate an electron beam having an energy in a range of 60 keV to 300 keV, with a tolerance in a range of ±0.7 keV to ±1.5 keV. For example, the electron source may be configured to generate an electron beam of 200 keV ±1.2 keV. Likewise, the electron source may be configured to generate an electron beam of 160 keV having a ripple of 80 eV peak-to peak. The electron source may be configured to be operated at one or more constant acceleration voltages. Alternatively, the electron source may be configured to generate a beam of electrons having a selectable energy.

As defined above, the charged-particle beam device is configured to form a substantially parallel charged-particle beam at a predefined sample position in the diffraction mode. Used herein, the term "substantially parallel charged particle beam" refers to a charged particle beam having a convergence angle less than or equal to an upper limit of 0.5°. However, different, in particular much smaller upper limits of the convergence angle may be more preferable, like 0.1°, in particular 0.05°, more particularly 0.025°, preferably 0.01°. As used herein, the convergence angle refers to the half opening angle of the charged particle beam.

### BRIEF DESCRIPTION OF THE DRAWINGS

- FIG. 1:: schematically shows the principal setup of a charged-particle beam device according to a first exemplary embodiment of the present invention; and
- Fig. 2:: schematically shows a second exemplary embodiment of the charged-particle beam device according to the present invention;
- Fig. 3:: schematically shows a third exemplary embodiment of the charged-particle beam device according to the present invention; and
- Fig. 4:: schematically shows a fourth exemplary embodiment of the charged-particle beam device according to the present invention.

### DETAILED DESCRIPTION OF EMBODIMENTS

The subject matter is now described with reference to the drawings, wherein like reference numerals are used to refer to like elements throughout.

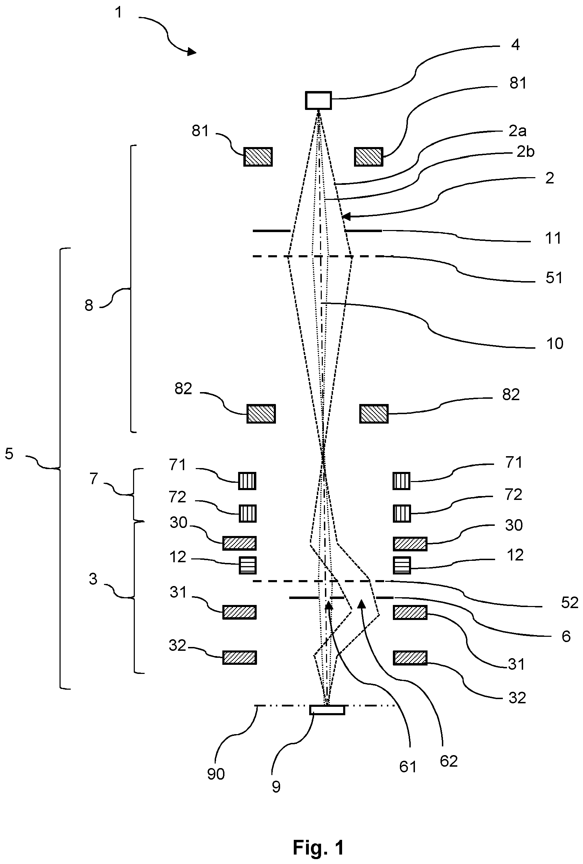

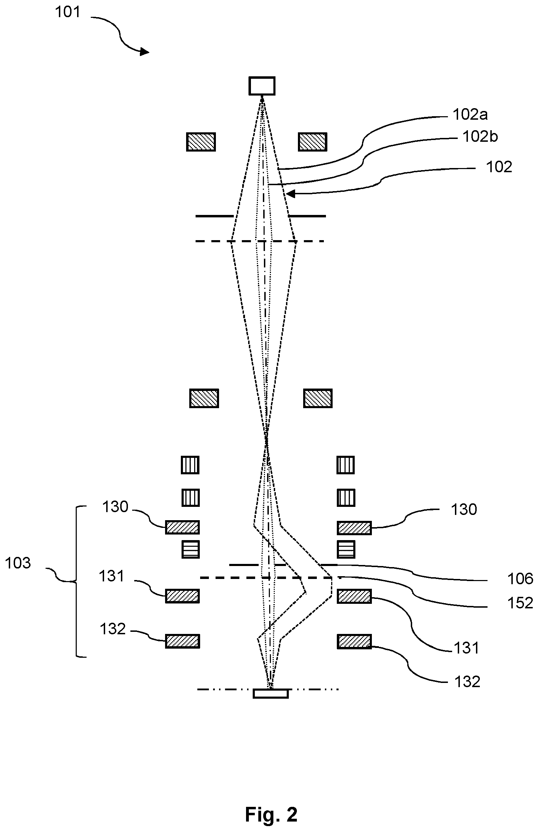

Fig. 1 (not to scale) schematically shows the principal setup of a charged-particle beam device 1 according to a first exemplary embodiment of the present invention. In the present embodiment, the charged-particle beam device 1 is designed as an electron beam device that uses a beam of electrons with a kinetic energy of about 160 keV as a charged-particle beam 2. All numbers (including those which are presented in the following) are valid for the embodiment of the charge-particle beam device 1 as shown in Fig. 1, and consequently in subsequent Figs. 2-4, yet incremented by multiples of 100. It is to be understood that different numbers can be used as well, depending on the exact requirements.

A charged-particle source 4, here an electron gun, is used for generating the charged-particle beam 2 of electrons. Due to the nature of the electron gun, the charged-particle beam 2 is divergent when escaping from the electron gun. That is, the charged-particle source 4 emits a roughly cone-shaped charged-particle beam 2. For reference, a center axis 10 of the charge-particle beam device 1 (optical axis) is also indicated in Fig. 1.

In order to stop and remove those parts of the charged-particle beam 2 that are too divergent, when escaping from the charged-particle source 4, the beam device 1 comprises a scraping aperture 11 which is arranged downstream the charged-particle source 4 as seen on the propagating direction 10 (indicated by an arrow in Fig. 1) of the charged-particle beam 2. Preferably, the scraping aperture 11 is cooled by a cooling equipment (not shown) in order to remove heat from the scraping aperture 11 that is generated by dissipating the impact energy of the 160 keV electrons impacting the scraping aperture 11.

Downstream the scraping aperture 11, the charged-particle beam 2 is passed through a charged-particle-optical system which comprises a charged-particle lens system 5 and a beam-limiting multiple-aperture stop 6 for limiting the beam diameter. According to the invention, the lens system 5 consists of two magnetic lenses only, namely, a first magnetic lens 51 and a second magnetic lens 52, where the numbering of the magnetic lenses 51, 52 is chosen according to the direction of the charged particles of the charged-particle beam 2. Each of the two magnetic lenses 51, 52 has a variable focal length which can be varied purely electrically, in particular by applying a different electric current. In the present embodiment, the beam-limiting multiple-aperture stop 6 is arranged downstream the second magnetic lens 52. It is to be noted that both the scraping aperture 11 and the beam-limiting multiple-aperture stop 6 are placed at a fixed position along and transverse to the optical axis 10 of the charged-particle-optical system.

As described further above, the charged-particle-optical system according to the present invention is configured to be selectively operated in two modes, an imaging mode and a diffraction. In the diffraction mode the charged-particle-optical system is configured to form a substantially parallel charged-particle beam 2 at a predefined sample position 90, where a sample 9 to be analyzed is placed, for example, on a sample support. In the imaging mode the charged-particle-optical system is configured to form a focused charged-particle beam 2 having a focus at the predefined sample position 90. This is illustrated in Fig 1, where lines 2a (not to scale) show the beam path in the imaging mode, and lines 2b (not to scale) show the beam path in the diffraction mode. It is to be noted that in the presently depicted example "substantially parallel" means that the charged-particle beam is slightly divergent having an angle of divergence of about 5° at the predefined sample position 90. Primarily, the charged-particle-optical system according to the present invention is designed to analyze the sample in the diffraction mode. In particular, the device 1 is designed for charged-particle crystallography of crystalline samples, whereas the imaging mode is (only) used to take a series of overview pictures in order to identify a specific sample or particle which the diffraction experiment is to be performed on.

According to the present invention, switching between the imaging mode and the diffraction mode is achieved by selectively directing the beam 2 through one or the other of two different-sized apertures 61, 62 provided on the beam-limiting multiple-aperture stop 6, accompanied by changing the focal length of at least the first magnetic lens. As can be seen in Fig. 1, the beam-limiting multiple-aperture stop 6 comprises a first aperture 61 and a second aperture 62, wherein in the present embodiment the aperture size of the first aperture 61 is about 5.1 micrometer and thus smaller than the aperture size of the second aperture 62 which is about 164 micrometer. In the diffraction mode the charged-particle beam 2 passes through the first aperture 61 (see lines 2b), whereas in the imaging mode it passes through the second aperture 62 (see lines 2a).

For selectively directing the charged-particle beam 2 through either the first aperture 61 or the second aperture 62, the optical system shown in Fig. 1 comprises an aperture-swap deflector system 3, which comprises a first aperture-swap deflector subsystem 30 arranged upstream the beam-limiting multiple-aperture stop 6 and a second aperture-swap deflector subsystem 31, 32 arranged downstream the beam-limiting multiple-aperture stop 6. The first aperture-swap deflector subsystem 30 comprises a pair of two electromagnets which are capable of deflecting the charged-particle beam 2 in the view plane of Fig 1 to direct the beam 2 through either the first aperture 61 or the second aperture 62. In contrast, the second aperture-swap deflector subsystem 31, 32 comprises two pairs of electromagnets which are configured and arranged to (re-)direct the beam 2 downstream of the beam-limiting multiple-aperture stop 6 onto the optical axis 10 and the predefined sample position 90, respectively. Thus, switching between the imaging mode and the diffraction mode advantageously may be achieved purely electrically without effectuating mechanical movements of any components, i.e. by electrically controlling the charged-particle lens system 5 and the aperture-swap deflector system 3.

In the present embodiment, in the imaging mode (see exemplary charged-particle path of the imaging mode 2a), the focal length F1 of first magnetic lens 51 is set to 4 mm, while the focal length F2 of second magnetic lens 52 is set to 18 mm. This will result in a convergent charged-particle beam 2 at the predefined sample position 90 in a way that the diameter of the charged-particle beam 2 at the sample position 90 is about 41 nm in the imaging mode (see exemplary charged-particle path in the imaging mode 2a).

In the diffraction mode, in which the charged-particle beam 2 is substantially parallel at the predefined sample position 90 (with a divergence angle of about 5°), the focal length F1 of the first magnetic lens 51 is set to 20 mm, while the focal length F2 of the second magnetic lens 52 is set to (in particular kept at) 18 mm. This results in a diameter of the charged-particle beam 2 at the predefined sample position 90 of approximately 250 nm.

The distance between the charged-particle source 4 and the first magnetic lens 51 as well as the distance between the first magnetic lens 51 and the second magnetic lens 52 each is about 200 mm. The predefined sample position 90 is located about 20 mm downstream of the second magnetic lens 52. In total, the distance between the charged-particle source 4 and the predefined sample position 90 is about 420 mm.

As further illustrated in Fig. 1, the optical system according to the present embodiment also comprises a scanning deflector system 7 and an alignment deflector system 8.

The scanning deflector system 7 is arranged between the first magnetic lens 51 and the second magnetic lens 62, upstream the first aperture-swap deflector subsystem 30. The scanning deflector system 7 comprises a first scanning beam deflector 71 and a second scanning beam deflector 72, each of which includes a pair of electromagnets which together form a double deflector configured and arranged to scan the charged-particle beam 2 at the predefined sample position 9 in two dimensions. Advantageously, this allows for operating the charged-particle beam device 1 in a scanning imaging mode which is essentially equivalent to the scanning imaging mode of a scanning transmission electron microscope (STEM) or a raster-scanning transmission electron microscope (RSTEM). The pivot point of the scanning deflector system 7 preferably is on the optical axis 10 in a principal plane of the second magnetic lens 52 in order to facilitate the operational implementation of a scanning imaging mode. Usually, the scanning deflector system 7 will only be active (if at all), if the charge-particle beam device 1 is operated in a scanning imaging mode, in which the exemplary charged-particle path of the imaging mode 2a is the active one. However, the scanning deflector system 7 might be active in both modes, i.e. in the diffraction mode as well as in the imaging mode.

The alignment deflector system 8 comprises at least a first alignment beam deflector 81 arranged upstream the first magnetic lens 51 and a second alignment beam deflector 82 arranged between the first magnetic lens 51 and the second magnetic lens 52, upstream the scanning deflector system 7. The alignment deflector system 8 is configured to facilitate the initial alignment of the optical system. The second alignment beam deflector 82 may also be used as the first aperture-swap deflector subsystem 30, or vice versa. That is, either the second alignment beam deflector 82 or the first aperture-swap deflector subsystem 30 may be used to implement the function of both, the second alignment beam deflector 82 and the first aperture-swap deflector subsystem 30.

In order to correct a possible astigmatism of the charged-particle beam 2, the optical system further comprises a charged-particle stigmator 12 which is arranged between the first magnetic lens 51 and the second magnetic lens 52, more particularly between the first aperture-swap deflector subsystem 30 and the second magnetic lens 52. The stigmator 12 may be active in imaging mode (exemplary charged-particle path 2a), in the diffraction mode (exemplary charged-particle path 2b), or in both.

Fig. 2 (not to scale) schematically shows a second exemplary embodiment of the charged-particle beam device 101 according to the present invention, which is similar to the first embodiment of the device 1 shown in Fig. 1. Hence, identical or similar features are denoted with identical reference signs, yet incremented by 100. In contrast to the first embodiment, the beam-limiting multiple-aperture stop 106 of the device 101 according to the second embodiment is arranged between the first magnetic lens 151 and the second magnetic lens 152, more particularly between the stigmator 112 and the second magnetic lens 152. Preferably, the beam-limiting multiple-aperture stop 106 is arranged at a position upstream the second magnetic lens 152 where the beam diameters in the respective modes are similar to the beam diameters at the downstream position of the beam-limiting multiple-aperture stop 6 in Fig. 1.

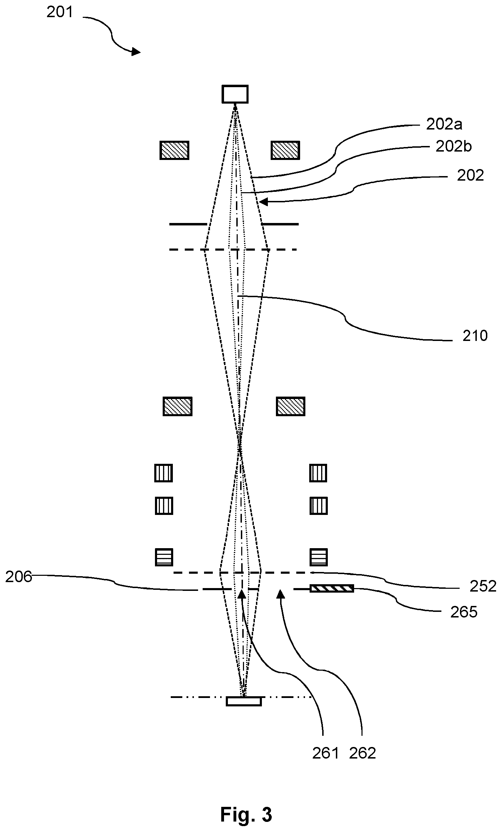

Fig. 3 (not to scale) schematically shows a third exemplary embodiment of the charged-particle beam device 201 according to the present invention, which is also similar to the first embodiment of the device 1 shown in Fig. 1. Hence, identical or similar features are denoted again with identical reference signs, yet incremented by 200. In contrast to the device 1 according to first embodiment which comprises a beam-limiting multiple-aperture stop having a fixed position in combination with an aperture-swap deflector system, the device 201 according to the third embodiment comprises a beam-limiting multiple-aperture stop 206 which is movable by means of an aperture-swap translation stage 265 in at least one dimension within a movement plane perpendicular to the optical axis 210 of the charged-particle-optical system such that in a first position of the beam-limiting multiple-aperture stop 206 the charged-particle beam 202 passes through the first aperture 261 in the diffraction mode and that in a second position of the beam-limiting multiple-aperture stop 261 the charged-particle beam 202 passes through the second aperture 262 in the imaging mode. Thus, the appropriate aperture 261, 262 for the diffraction mode and the imaging mode, respectively, can be moved into the charged-particle beam 202 without the need for deflecting the beam. Advantageously, the aperture-swap translation stage 265 allows for a remote control of the aperture stop movement. To ensure a proper performance of the respective beam-limiting apertures 261, 262, the aperture-swap translation stage 265 preferably is configured to position the beam-limiting multiple-aperture stop 206 at the first position and the second position with an accuracy of at most ± 5 nanometer, in particular ±1 nanometer within the movement plane. In the present embodiment, the aperture-swap translation stage 265 comprises a piezo actuator which proves advantageous since piezo actuators are vacuum-compatible and capable of positioning the apertures 261, 262 within the above-mentioned accuracy ranges.

In Fig. 3, the beam-limiting multiple-aperture stop 206 is arranged downstream the second magnetic lens 252 at a similar position as the beam-limiting multiple-aperture stop 6 in Fig. 1.

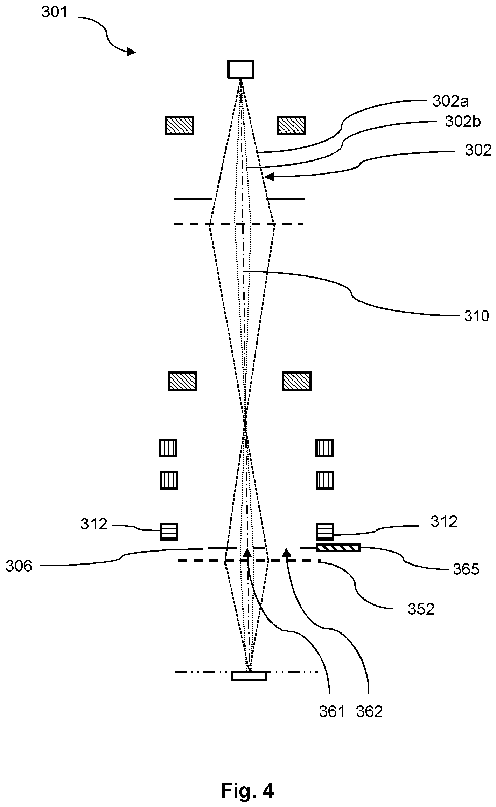

Alternatively, as shown in Fig. 4 which illustrates a fourth embodiment of the charged-particle beam device 301, the beam-limiting multiple-aperture stop 306 can be arranged upstream the second magnetic lens 352, more particularly between the stigmator 312 and the second magnetic lens 352. Apart from that, the fourth embodiment of the charged-particle beam device 301 according to Fig. 4 is similar to the third embodiment of the device 201 shown in Fig. 3. Hence, identical or similar features in Fig. 4 are denoted with the same reference signs as in Fig. 3, yet incremented by 100.

## Claims

1. A charged-particle beam device (1,101) for charged-particle crystallography of crystalline samples, comprising a charged-particle source (4) for generating a charged-particle beam (2, 102) to be radiated onto a sample (9) and a charged-particle-optical system downstream the charged-particle source (4), which is configured to form in a diffraction mode a substantially parallel charged-particle beam (2, 102) at a predefined sample position (90) and in an imaging mode a focused charged-particle beam (2, 102) having a focus at the predefined sample position (90), the charged-particle-optical system comprising:
- a charged-particle lens system (5) consisting of a first magnetic lens (51) and a second magnetic lens (52, 152) downstream the first magnetic lens (51), wherein at least the first magnetic lens (51), preferably each one of the first (51) and the second (52, 152) magnetic lens has a variable focal length,
- a beam-limiting multiple-aperture stop (6, 106) comprising at least a first aperture (61, 161) and a second aperture (62, 162) for limiting the diameter of the charged-particle beam,
- an aperture-swap deflector system (3) configured to selectively direct the charged-particle beam (2) through the first aperture (61, 161) in the diffraction mode and through the second aperture (62, 162) in the imaging mode.

2. The charged-particle beam device (1,101) according to claim 1, wherein the beam-limiting multiple-aperture stop (6, 106) is arranged at a fixed position, in particular along and transverse to an optical axis (10) of the charged-particle-optical system.

3. The charged-particle beam device (1,101) according to any one of the preceding claims, wherein the aperture-swap deflector system (3, 103) comprises a first aperture-swap deflector subsystem (30, 130) arranged upstream of the beam-limiting multiple-aperture stop (6, 106).

4. The charged-particle beam device (1, 101) according to claim 3, wherein the aperture-swap deflector system (3, 103) comprises a second aperture-swap deflector subsystem (31, 131, 32, 132) arranged downstream of the beam-limiting multiple-aperture stop (6, 106).

5. A charged-particle beam device (201, 301) for charged-particle crystallography of crystalline samples, comprising a charged-particle source (4) for generating a charged-particle beam (202, 302) to be radiated onto a sample (9) and a charged-particle-optical system downstream the charged-particle source (4), which is configured to form in a diffraction mode a substantially parallel charged-particle beam (202, 302) at a predefined sample position (90) and in an imaging mode a focused charged-particle beam (202, 302) having a focus at the predefined sample position (90), the charged-particle-optical system comprising:
- a charged-particle lens system (5) consisting of a first magnetic lens (51) and a second magnetic lens (252, 352) downstream the first magnetic lens (51), wherein at least the first magnetic lens (51), preferably each one of the first (51) and the second (252, 352) magnetic lens has a variable focal length,
- a beam-limiting multiple-aperture stop (206, 306) comprising at least a first aperture (261, 361) and a second aperture (261, 361) for limiting the diameter of the charged-particle beam, wherein the beam-limiting multiple-aperture stop (206, 306) is movable in at least one dimension within a movement plane perpendicular to an optical axis (210, 310) of the charged-particle-optical system (5),
- an aperture-swap translation stage (265, 365) configured to move the beam-limiting multiple-aperture stop (206, 306) between different positions within the movement plane such that in a first position of the beam-limiting multiple-aperture stop (206, 306) the charged-particle beam (202, 302) passes through the first aperture (261, 361) in the diffraction mode and that in a second position of the beam-limiting multiple-aperture stop (261, 361) the charged-particle beam (202, 302) passes through the second aperture (262, 362) in the imaging mode.

6. The charged-particle beam device (201, 301) according to claim 5, wherein the aperture-swap translation stage is configured to position the beam-limiting multiple-aperture stop (206,306) at the first position and the second position with an accuracy of at most ± 5 nanometer, in particular ±1 nanometer within the movement plane.

7. The charged-particle beam device (201, 301) according to claim 5 or claim 6, wherein the aperture-swap translation stage comprises an actuator, in particular an electrical actuator for moving the beam-limiting multiple-aperture stop.

8. The charged-particle beam device (101) according to any one of the preceding claims, wherein the beam-limiting multiple-aperture stop (106) is arranged between the first magnetic lens (151) and the second magnetic lens (152); or wherein the beam-limiting multiple-aperture stop (6) is arranged downstream the second magnetic lens (52).

9. The charged-particle beam device (1, 101, 201, 301) according to any one of the preceding claims, wherein the charged-particle-optical system is configured such that the diameter of the charged-particle beam (2) at the sample position (90) is in a range between 100 nanometer and 1000 nanometer, in particular between 220 nanometer and 250 nanometer in the diffraction mode, and in a range between 10 nanometer and 200 nanometer in the imaging mode.

10. The charged-particle beam device (1, 101, 201, 301) according to any one of the preceding claims, wherein the first aperture (61, 161, 261, 361) has an aperture diameter in a range between 1 micrometer and 10 micrometer, in particular between 4 micrometer and 7 micrometer; and/or wherein the second aperture (62, 162, 262, 362) has an aperture diameter in a range between 100 micrometer and 200 micrometer, in particular between 150 micrometer and 175 micrometer.

11. The charged-particle beam device (1, 101, 201, 301) according to any one of the preceding claims, wherein the charged-particle-optical system further comprises a scanning deflector system (7) arranged between the first magnetic lens (51) and the second magnetic lens (52, 152, 252, 352) for two-dimensionally scanning the charged-particle beam (2, 102, 202, 302) at the predefined sample position (90).

12. The charged-particle beam device (1, 101, 201, 301) according to claim 11, wherein the scanning deflector system (7) comprises a first scanning beam deflector (71) and a second scanning beam deflector (72).

13. The charged particle beam device (1, 101, 201, 301) according to any one of the preceding claims, wherein the charged-particle optical system further comprises an alignment deflector system (8), wherein the alignment deflector system comprises at least a first alignment beam deflector (81) arranged upstream the first magnetic lens (51) and preferably a second alignment beam deflector (82) arranged between the first magnetic lens (51) and the second magnetic lens (52, 152, 252, 352).

14. The charged-particle beam device (1, 101, 201, 301) according to any one of the preceding claims, further comprising a scraping aperture (11) arranged between the charged-particle source (4) and the first magnetic lens (51, 152, 252, 352).

15. The charged-particle beam device (1, 101, 201, 301) according to any one of the preceding claims, wherein the charged-particle-optical system further comprises a charged-particle stigmator (12, 112) arranged downstream the first magnetic lens (51, 151) to correct for astigmatism.
